(19) Europäisches Patentamt
European Patent Office
Office européen des brevets

(11) **EP 4 106 022 A1**

(12) # EUROPEAN PATENT APPLICATION

(43) Date of publication:
**21.12.2022   Bulletin 2022/51**

(21) Application number: **21305827.4**

(22) Date of filing: **17.06.2021**

(51) International Patent Classification (IPC):
**H01L 33/50** (2010.01)    **G01T 1/20** (2006.01)
**H01L 25/075** (2006.01)

(52) Cooperative Patent Classification (CPC):
**H01L 33/505; G01T 1/2002; G01T 1/20185;
H01L 33/507;** H01L 25/0753

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Centre national de la recherche scientifique
75016 Paris (FR)**
• **Université Paris-Saclay
91190 Saint-Aubin (FR)**

• **Institut Optique Theorique Appliquee
91127 Palaiseau Cedex (FR)**

(72) Inventors:
• **BALEMBOIS, François
91870 BOISSY LE SEC (FR)**
• **PICHON, Pierre
91120 PALAISEAU (FR)**

(74) Representative: **Atout PI Laplace
Immeuble "Visium"
22, avenue Aristide Briand
94117 Arcueil Cedex (FR)**

(54) **OPTIMIZED LIGHT EMITTING DEVICE**

(57)    Light emitting device (1) comprising a solid fluorescent material or a solid scintillator material (CL) adapted to absorb an incident light (Ld) and then emit a luminescent light (LL) in said material, a portion, called trapped portion (Lp), of said luminescent light being trapped by total internal reflections in said material, said material comprising two parallel faces, called large faces (FE1, FE2), along an horizontal plane xy, and n ∈ N>2 faces called side faces (FL1, FL2, FL3, F4), and forming vertex (S2, S3, S4) between two adjacent side faces and a large face, wherein said material has an invariance of the normals to said side faces by rotation by an angle of $2\pi/n$ in said horizontal plan around a z-axis perpendicular to said horizontal plane, wherein said material has a vertex called virtual vertex (S1) that is beveled thus forming a surface called beveled vertex (SB1), or wherein said material has an edge between two side faces, called virtual edge (S1S5), that is beveled thus forming a surface beveled edge (SB1), a portion of the rays of said trapped portion passing through said beveled surface thus forming an exit beam (LS), wherein a normal ($\vec{n}$) to said beveled vertex is parallel to the sum of the normal of the faces forming said virtual surface, within ± 10°.

[Fig.4A]

Fig.4A

## Description

## Technical field:

The present invention concerns the field of light concentrators, and more particularly to the extraction of light emitted in concentrators.

## Prior Art:

Light-emitting diodes (LEDs) have many applications in the field of lighting. However, the luminance of LEDs is limited to values that are not suitable for some applications.

One solution to increase the luminance of LEDs is to use LED-pumped luminescent concentrators (see for example Barbet, Adrien, et al. "Light-emitting diode pumped luminescent concentrators: a new opportunity for low-cost solid-state lasers." Optica 3.5 (2016): 465-468.). This concentrator is, for example, a crystal that emit fluorescent light in the visible (red-orange) range, such as Ce:YAG, which absorbs in the blue range (around 450 nm), at a wavelength where LEDs are very efficient. The crystal is cut in the form of a plane, lined by hundreds (even thousands) of LEDs on both large surfaces and with an emission by the edges. These concentrators can achieve luminance values 10 to 20 times higher than that of an LED.

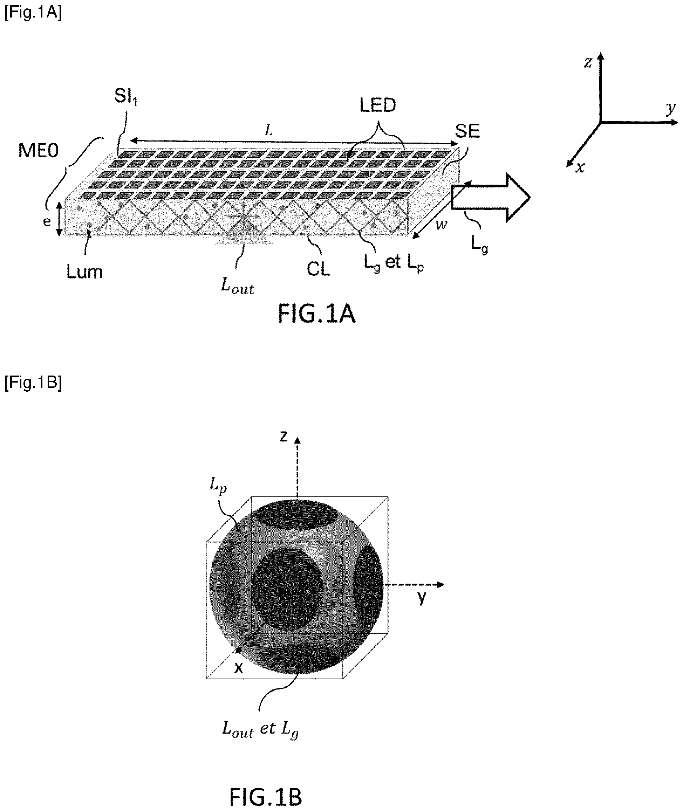

Figure 1A illustrates an example of a light emitting module ME0 known in the prior art based on a concentrator crystal CL. Figure 1A schematically represents a perspective view of the emission module ME0. The emission module ME0 comprises a set of LEDs emitting in a first spectral band, and a light concentrator CL. The concentrator CL is a fluorescent parallelepiped crystal, having at least one illumination face SI1, SI2, of dimensions $L \times w$, illuminated by the electroluminescent radiation Ld emitted by the LEDs. The illumination faces SI1, SI2 are also called "large faces". The thickness of the concentrator is noted e.

The crystal of the concentrator is configured to absorb said electroluminescent radiation Ld. The luminous flux emitted by the LEDs and directed towards the illumination face is absorbed by the luminophores Lum of the fluorescent crystal which are distributed throughout the volume of the crystal and which then emit fluorescence radiation inside the crystal. The emitted rays can be classified in two main categories:

- trapped rays noted Lp: these rays are trapped in the crystal due to the total internal reflection (TIR) on the different faces of the crystal. These rays exist if the crystal is a parallelepiped with 6 faces parallel two by two and perpendicular to each other. The trapped rays never leave the crystal.

- the untrapped rays are the rays that eventually leave the crystal. They can be separated into two sub-categories: guided rays Lg, which are guided by RTI and emerge on one of the faces of the concentrator, and unguided rays Lout, which emerge directly from the concentrator without being reflected on the faces.

Figure 1B is a representation of the angular diagram of all the rays emitted and trapped in the concentrator. The dark caps represent the angles corresponding to the untrapped rays (guided $L_g$ and unguided $L_{out}$) and the lighter areas represent the angles corresponding to the trapped rays $L_p$. In this representation given as an example, the medium chosen as the concentrator crystal CL is a Ce:YAG crystal (index n=1.82) having a critical angle of 33° when the ambient medium is air. The percentage of radiation trapped by RTI compared to the untrapped radiation is fixed by the index of the crystal and that of the ambient medium by the Snell-Descartes law.

In the parallelepiped concentrator of figure 1A, the share of light exiting on the exit face SE is 8%, assuming an exit index n=1 (air) and a concentrator index n=1.82 (eg: YAG). The rest of the light exits on the other faces (5x8%) or remains trapped inside the concentrator by total internal reflections (52%) (see figure 1B). For a parallelepiped concentrator in diamond (n=2.4) in air, the percentage of trapped ray increases to 73%. To increase the efficiency, it is known from one skilled in the art to place a mirror on the face opposite to the exit face. However, the efficiency in each direction of the parallelepiped remains limited to 2x8%=16%, at most in Ce:YAG and 2*4,5%=9% at most in diamond.

Light extraction from emitting crystals has been a crucial topic for the past 50 years in the field of scintillators (see C.M Ankenbrandt and E.M.Lent "Increasing the light collection efficiency of scintillation counters", RSI Vol 34 N°6 p647 (1963)). It has been the subject of many publications with multiple ideas for extraction. This point is all the more important in the field of scintillator crystals because these crystals often have high indices (Ce:YAG n=1.83, BGO n=2.15, for example), making light trapped by total internal reflections very important (52% in Ce:YAG, 65% in BGO for a parallelepiped geometry).

This subject has reappeared in another scientific community in the field of quantum optics with the emission of single photons in diamonds including nitrogen vacancy (NV) centers. Here again different solutions have been explored to extract the light. This point is particularly crucial in diamond because its index is very high (n=2.4) (73% of the rays are trapped in a parallelepiped).

Once the light is extracted, it is necessary to be able to use it. In general, an important extraction implies a very high numerical aperture of the output beam. The use of immersion microscopes is a first solution to collect the fluorescence of NV centers and to allow the radiation to propagate to the detector. However, there is still a need to improve light extraction in diamonds with NV centers.

A similar problem arises in the field of scintillators crystals. Scintillators crystals transform very energetic incident radiation (X or gamma) into visible radiation detectable with "classical" detectors such as photo-multipliers or photodiodes. Scintillators must meet several constraints:

- the flux of light detected must be maximal in order to allow the detection of rare events, requiring a high sensitivity.

- the detector must be fast in order to be able to differentiate events very close in time.

- the scintillator must give an identical response for all the absorbed X or gamma photons that arrive with a given energy. The response is called "photopic". The way to quantify the quality of this response is the "energy resolution". It consists in making a histogram of the events recorded in the scintillator by classifying them according to their intensity of emission from the scintillator. The energy resolution is strongly dependent on the scintillator operating conditions and its geometry. The resolution also depends strongly on the light that can be extracted. It depends on the reflectivity of the faces and the nature of the surface state (polished or scattering). The coupling in an optical fiber degrades the energy resolution because the useful flux is less important due to the coupling efficiency. Therefore, light extraction efficiency is a critical issue in this field.

The invention aims to alleviate certain problems of the prior art. To this end, an object of the invention is a light emitting device comprising a solid fluorescent crystal or a solid scintillator crystal comprising a beveled vertex or a beveled edge with a normal having a direction adapted to recycle a high number of trapped rays and therefore increase the light extraction efficiency of the device and increase the power and luminance of the exit beam passing through the beveled vertex or the beveled edge.

**Summary of the invention** :

To this end, an object of the invention according to a first variant is a light emitting device comprising a solid fluorescent material or a solid scintillator material adapted to absorb an incident light and then emit a luminescent light in said material, a portion, called trapped portion, of said luminescent light being trapped by total internal reflections in said material, said material comprising two parallel faces, called large faces, along an horizontal plane *xy,* and $n \in \mathbb{N} > 2$ faces called side faces, and forming vertex between two adjacent side faces and a large face, wherein said material has an invariance of the normals to said side faces by rotation by an angle of $2\pi/n$ in said horizontal plan around a z-axis perpendicular to said horizontal plane, wherein said material has a vertex called virtual vertex that is beveled thus forming a surface called beveled vertex, a portion of the rays of said trapped portion passing through said beveled vertex thus forming an exit beam, wherein a normal to said beveled vertex is parallel to the sum of the normal of the faces forming said virtual vertex, within±10°.

In a preferred embodiment of the first variant, the material is a rectangular parallelepiped.

In a preferred embodiment of the first variant, an angular coordinates of said normal to said beveled vertex in an xyz frame of reference are $(\alpha=\pm45°;\beta=\pm35,3°)\pm10°$.

Another object of the invention according to a second variant is a light emitting device comprising a solid fluorescent material or a solid scintillator material adapted to absorb an incident light and then emit a luminescent light in said material, a portion, called trapped portion, of said luminescent light being trapped by total internal reflections in said material, said material comprising two parallel faces, called large faces, along an horizontal plane *xy,* and $n \in \mathbb{N} > 2$ faces called side faces wherein said material has an invariance of normals to said side faces by rotation by an angle of $2\pi/n$ in said horizontal plan around a z-axis perpendicular to the horizontal plane, wherein said material has an edge between two side faces, called virtual edge, that is beveled thus forming a surface beveled edge, a portion of the rays of said trapped portion passing through said beveled edge forming an exit beam, wherein the normal to said beveled vertex is parallel to the sum of the normal of the two side faces forming the virtual edge, within ± 10°.

In a preferred embodiment of the invention compatible with the first and second variant, the device comprises a plurality of mirrors covering said side faces except for said beveled edge or said beveled vertex.

In a preferred embodiment of the invention compatible with the first and second variant, the material has an attenuation coefficient of said luminescent light $\alpha$ such that $\dfrac{1}{\alpha} \gg 2L,$ with *L* a maximum distance between two parallel side faces.

In a preferred embodiment of the invention compatible with the first and second variant, the material is a diamond crystal having nitrogen vacancy centers, said incident radiation being emitted by a laser illuminating at least one face of the crystal.

In a preferred embodiment of the invention compatible with the first and second variant, the side faces are perpendicular to the large faces.

In a preferred embodiment of the invention compatible with the first and second variant, the device comprises a tapered conical adapter attached by a so-called upstream end adjacent to said beveled edge or vertex and an optical fiber connected to a so-called downstream end of the tapered adapter, said tapered adapter matching a numerical aperture of said exit beam to a numerical aperture of said optical fiber.

Another object of the invention is a x-ray or gamma-ray imaging system comprising an x-ray or gamma-ray source and a detector comprising:

- a plurality of identical light emitting devices according to any of the preceding claims, arranged to form an array, said material of each device being a solid scintillator,

- a plurality of photodiodes each arranged opposite of said beveled edge or said beveled vertex of the material of each device.

**Brief description of the drawings** :

Other features, details and advantages of the invention will become apparent from the description made with reference to the annexed drawings, which are given as examples and which represent, respectively:

[Fig. 1A], a light emitting module known in the prior art,

[Fig. 1B], the angular diagram of all the rays emitted and trapped in the prior art concentrator,

[Fig.2A], a light emitting device according to a first variant of the invention,

[Fig.2B], representation of the 3D angular diagram of all the rays emitted and trapped in the crystal of the first variant of the invention,

[Fig.2C], a trajectory of a ray emitted by a luminophore in the crystal of the first variant of the invention,

[Fig.3], a planar representation of the escape cones $L_g$, $L_{out}$ and $L_s$ using angular coordinates ($\alpha, \beta$) in the *xyz* frame of reference,[Fig.4A], a light emitting device according to a second variant of the invention,

[Fig.4B], representation of the 3D angular diagram of all the rays emitted and trapped in the crystal of the second variant of the invention,

[Fig.5A], [Fig.5B], the luminance of the exit beam, and the extraction efficiency, respectively, in function of the attenuation coefficient $\alpha$ for different configurations of crystals,

[Fig.5C], the different configurations used for figures 5A and 5B,

[Fig.6A], a light emitting device according the second variant of the invention wherein the crystal has 6 side faces,

[Fig.6B], a representation of the angular diagram of all the rays emitted and trapped in the crystal of figure 6A,

[Fig.7A], different configurations of crystals coupled with an optical fiber via a tapered conical adapter,

[Fig.7B], the light extraction efficiency, in function the diameter of the upstream end $\phi_u$, for the different configurations of crystals illustrated in figure 7A,

[Fig.8], a detector comprising a plurality of identical light emitting devices according to the first or second variant of the invention.

In the drawings, unless otherwise indicated, the elements are not to scale.

**Detailed specification** :

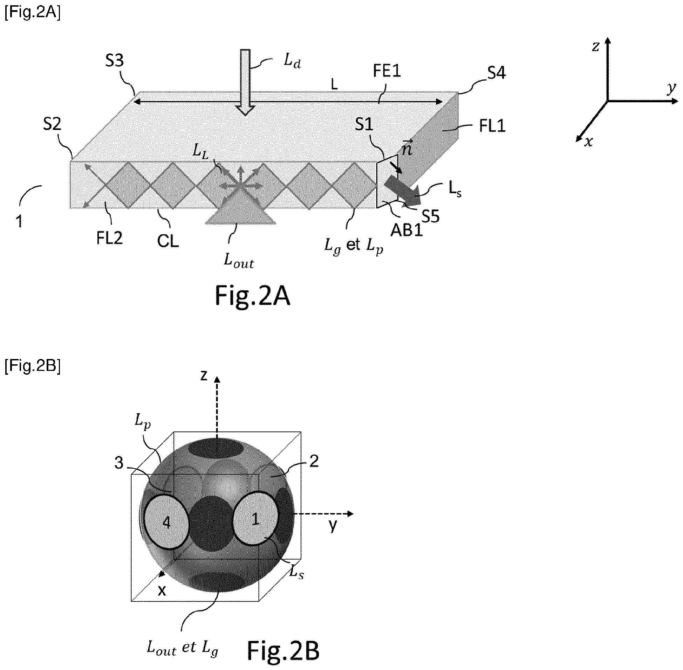

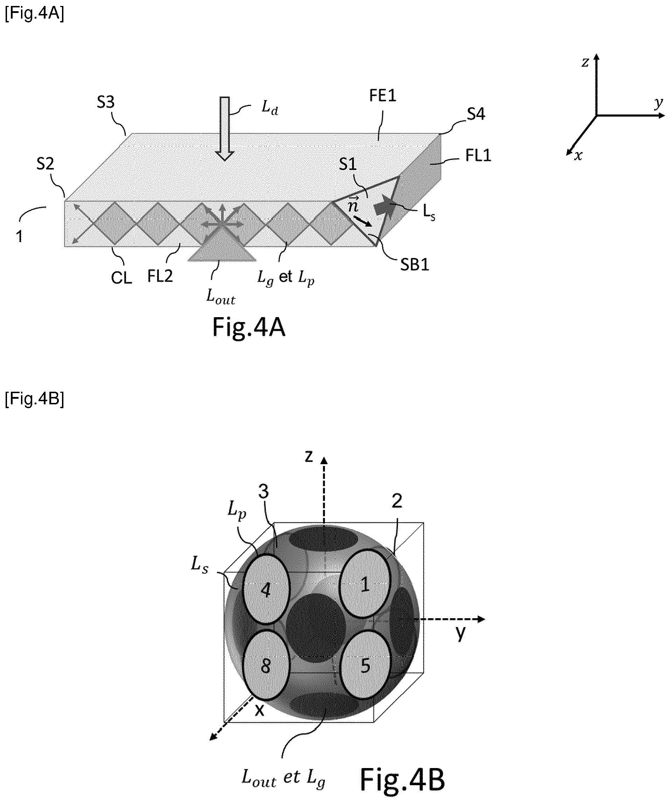

Figure 2A and Figure 4A illustrate a light emitting device 1 according to a first and a second variant of the invention respectively. The device 1 of the invention comprises a light concentrator which is a solid fluorescent crystal or a solid scintillator crystal, CL adapted to absorb an incident light Ld triggering the emission of a luminescent light $L_L$ in the crystal. In another embodiment, the light concentrator is not a crystal but another material, like glass. In the following, to simplify we will describe the device of the invention with a crystal, but it is understood that the invention can be realized with a light concentrator in another material adapted to absorb an incident light Ld triggering the emission of a luminescent light $L_L$ in the crystal.

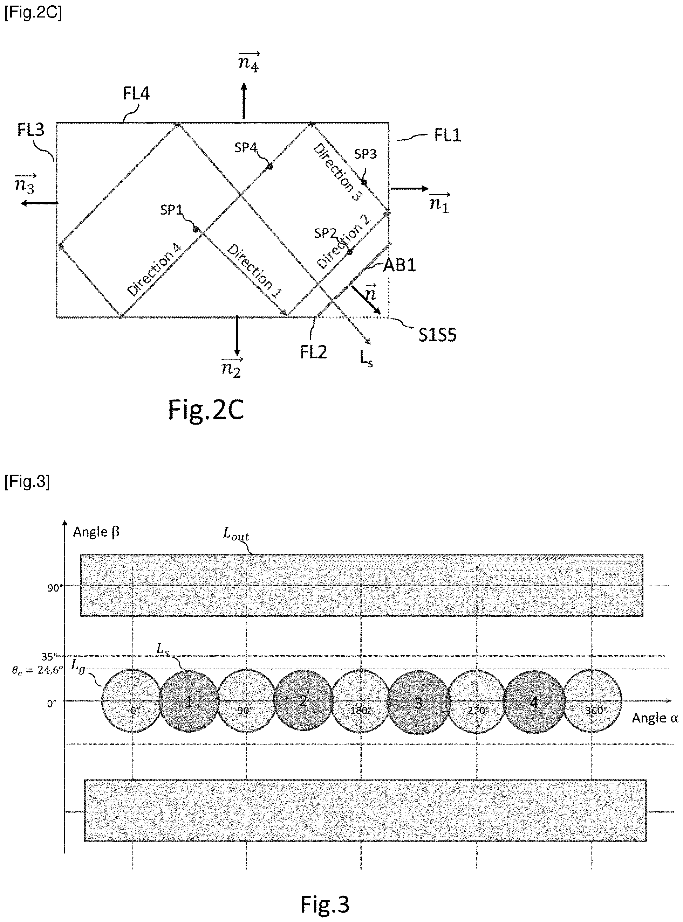

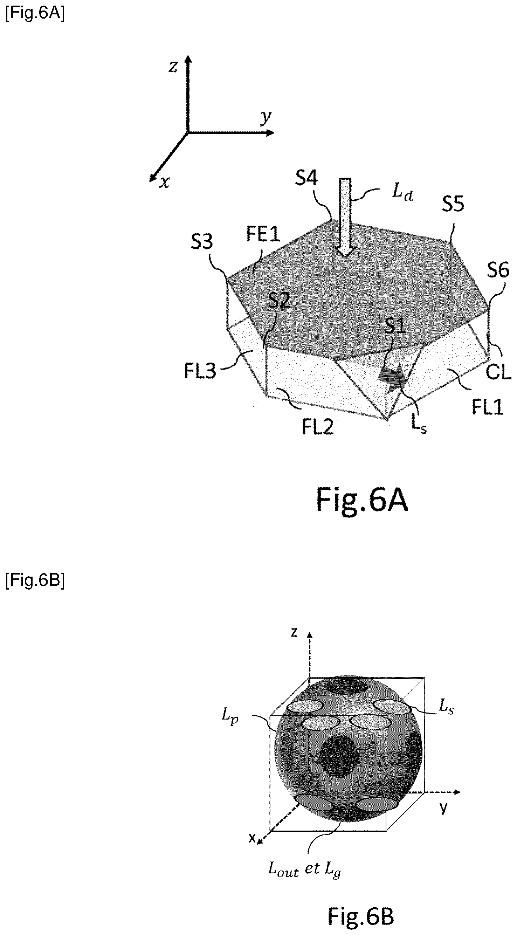

The crystal comprises two parallel faces, called large faces FE1, FE2, along a horizontal plane *xy* and comprises $n \in \mathbb{N} > 2$ faces, called side faces FL1, FL2, FL3, FL4. These side faces form vertex S1, S2, S3, S4, S5 between two adjacent side faces and a large face. Let us call $\vec{n_l}$ the normal to the side face FL$_i$ (see figure 2C). As an illustrative example, in figures 2A and 4A, the crystal CL is rectangular in shape and n=4. However, one skilled in the art will know that the invention also applies to crystals having a number higher than n=4 (see eg figure 6A).

As known to one skilled in the art, a portion, called trapped portion Lp, of said luminescent light is trapped by total internal reflection in said crystal. As previously stated, the ratio of trapped and untrapped rays is fixed by the index of the crystal and the index of the ambient medium, by the Snell-Descartes law. Trapped rays are noted Lp: these rays are trapped in the crystal due to the total internal reflection (TIR) on the different faces of the crystal. The untrapped rays are the rays that eventually leave the crystal. They can be separated into two sub-categories: guided rays Lg, which are guided by TIR on the large faces or side faces and emerge on one of the faces of the concentrator, and unguided rays $L_{out}$, which emerge directly from the concentrator without being reflected on the faces.

The invention aims at creating artificial escape cones related to trapped rays of the structure within a predetermined range of angles, and "recycling" those rays to increase the light extraction efficiency and increase the luminance and power of the beam exiting the crystal of the invention compared to what was previously achieved in prior art crystals. The term "recycling" in this context means allowing the trapped rays within a predetermined range of angles to escape the crystal but only after an incoherent superposition of those rays inside the crystal, thus increasing the luminance and power of the beam $L_S$ exiting the crystal.

To this end, the crystal of the invention has an invariance of the normals to the side faces by rotation by an angle of $2\pi/n$ in the horizontal plan $xy$ around a z-axis perpendicular to the horizontal plane. In the illustration of figure 2A and 4A, given as an example, n=4 and the normals to the side faces are invariant by rotation by an angle of $\pi/2$ around the z -axis.

To increase the light extraction efficiency, according to the first variant of the invention (illustrated in figure 2A), the crystal has an edge between two side faces FL1, FL2, called virtual edge S1S5 that is beveled thus forming a surface called beveled edge SB1 which normal $\vec{n}$ is in the plane of the large faces like the other normal of the lateral faces (see further). This beveled edge AB1 defines an exit face. The rays of the trapped portion passing through the beveled edge form the exit beam $L_S$.

According to the second variant of the invention (illustrated in figure 4A) the crystal has a vertex called virtual vertex S1 that is beveled thus forming a surface called beveled vertex SB1 which normal $\vec{n}$ is not in the plane of the large faces. Its direction is chosen to exploit the symetry of the structure (see further). This beveled vertex SB1 defines an exit face. The rays of the trapped portion passing through the beveled vertex form the exit beam $L_S$.

In each variant, the normal $\vec{n}$ to said beveled vertex or edge has a predetermined orientation adapted to "recycle" the most trapped rays and therefore increase the light extraction efficiency by exploiting the structure's symetry. Indeed, as will be explained later, the orientation of the normal to the beveled vertex or edge is the critical parameter controlling the predetermined range of angles of trapped rays that can exit the crystal through the exit face : the beveled edge or the vertex.

The first variant exploits the structure symmetry of the crystal in a plane. More precisely, in the first variant of the invention, the normal $\vec{n}$ to the beveled edge is parallel to the sum of the normal of the nearest side faces (ie: the faces forming the virtual edge), which means that : $\vec{n}$ is proportional to $\vec{n}_1 + \vec{n}_2$. A tolerance of the normal orientation is given by the dimension of the escape cone and the losses of the structure : a maximum angle of +/- 10° between $\vec{n}$ and $\vec{n}_1 + \vec{n}_2$ is acceptable. For an angle larger than 10°, light recycling is reduced and the light extraction efficiency of the crystal CL decreases in an unwanted fashion.

The second variant of the invention fully exploits the symmetry of the structure. Thus, in the second variant of the invention, the normal $\vec{n}$ to the beveled vertex is parallel to the sum of the normal of all the nearest faces (ie: the faces forming the virtual vertex), which means that $\vec{n}$ is proportional to $\vec{n}_1 + \vec{n}_2 + \vec{n}_{11}$, with $\vec{n}_{11}$ the normal to the large face FE1 forming the virtual vertex. A tolerance of the normal orientation is given by the dimension of the escape cone and the losses of the structure : a maximum angle of +/-10° between $\vec{n}$ and $\vec{n}_1 + \vec{n}_2 + \vec{n}_{11}$ is acceptable. For an angle larger than 10°, light recycling is reduced and the light extraction efficiency of the crystal CL decreases in an unwanted fashion.

Figure 2B and 4B are representations of the 3D angular diagram of all the rays emitted and trapped in the crystal CL. As in figure 1B, the dark caps represent the angles corresponding to the untrapped rays (guided $L_g$ and unguided $L_{out}$). The areas of medium intensity represent the angles corresponding to the trapped rays $L_p$. The lighter areas within the area of medium intensity are the escape cone 1 of the beveled surface and the images of the escape cone 1 created by the surfaces of the crystal, considered as mirrors (effect of total internal reflection for example). The rays forming the exit beam $L_s$, are mainly composed of trapped rays whose direction belong to the escape cone or to the images of the escape cone by the structure. Without the beveled edge or vertex, those rays would not have left the crystal. In this representation given as an example, the medium chosen as the concentrator crystal CL is a Ce:YAG crystal (index n=1.82) having a critical angle of 33° when the ambient medium is air.

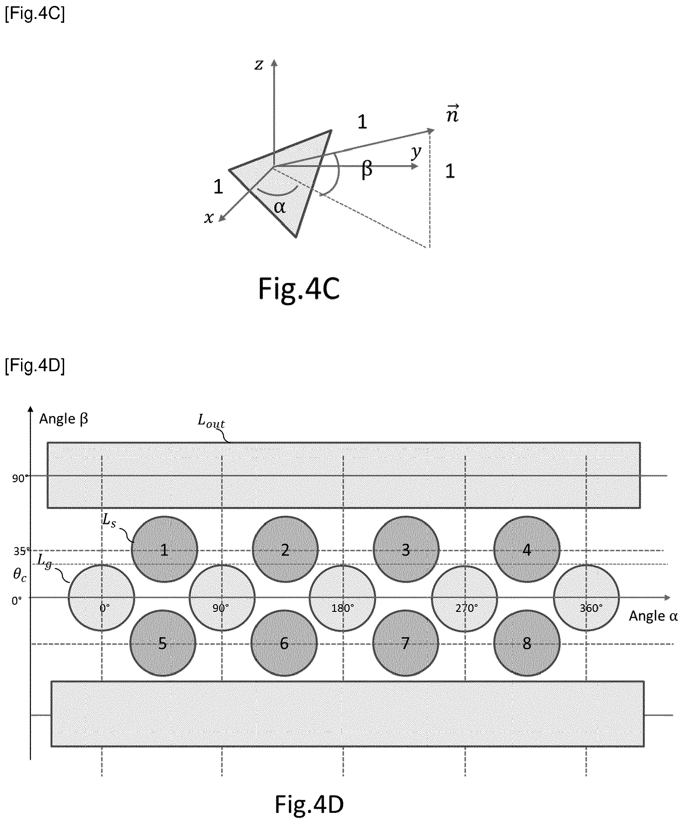

As can be seen in figure 2B, the beveled edge has created 1 escape cone (1) and three images (2-3-4) whereas in figure 4B, the beveled vertex has created 1 escape cone and seven images (2-3-4-5-6-7-8). The area of the escape cones in the angular representation of figure 2B and 4B (ie the range of angles of trapped rays exiting the crystal) is fixed by the critical angle of the TIR. In other words, the maximum angle of the escape cones of the rays forming the exit beam $L_s$ is equal to the critical angle $\theta_c$. It is therefore fixed by the index of the crystal and the index of the ambient medium, by the Snell-Descartes law. Figure 3 and figure 4D explains why the orientation of the escape cone -which axis is parallel to the normal $\vec{n}$- is critical for efficient light extraction. If it is not parallel to the sum of normals $\vec{n}_1 + \vec{n}_2$ for the first variant of the invention or $\vec{n}_1 + \vec{n}_2 + \vec{n}_{11}$ for the second variant of the invention, the escape cone of the beveled surface and its images can overlap the escape cones of the other faces. Minimizing this overlap is critical to achieve an efficient light extraction.

Figure 2C illustrates a trajectory of a ray emitted by the luminophore SP1 in the crystal CL. As an example, this ray has a trajectory along the horizontal plane *xy* in a direction 1 within the escape cone 1, and the normal to the beveled edge has angular coordinates ($\alpha$=45°; $\beta$=0°) in the O*xyz* frame of reference (a is the angle in the plane *xy* and $\beta$ is the angle with respect to the z axis). As previously stated, for this geometry, the normal $\vec{n}$ to the beveled edge is parallel to the sum of the normal of the nearest side faces : $\vec{n}_1 + \vec{n}_2$. For simplification, let us call this normal : "optimal normal". Given the rectangular shape of the crystal, the ray undergoes 6 changes of direction before exiting the crystal. From figure 2C, one can see that escape cone 1, the original cone of the ray, is transformed because of TIR on the side faces into an image cone 2, then image cone 3, then image cone 4, then image cone 3, then image cone 2, then image cone 1, before exiting through the beveled edge AB1. One would achieve the same exit point with the same orientation of ray with the luminophore SP2 with an emission in the image cone 2 in direction 2, or with the luminophore SP3 with an emission in the image cone 3 in direction 3, or with a luminophore SP4 with an emission in the image cone 4 in direction 4. This illustration shows that, in the first variant of the invention, light $L_s$ exiting through the beveled edge can come from 4 different cones of light. Therefore, the beveled edge can "recycle" 4 escape cones and incoherently sum rays from these 4 cones into exit beam $L_s$.

In opposite, in the prior art crystal of figure 1A, light exiting from one of the side faces can only come from one single cone of light. If one were to place a mirror on the face opposite to the exit face in the prior art crystal of figure 1A, light from said exit face could still only come from two cones of light. Thus, in theory, for a crystal of rectangular shape, the first variant of the invention (Fig.2A) can therefore lead to a light extraction efficiency four times higher than the light extraction efficiency of the prior art crystal of figure 1A. As a reminder, one calculates the light extraction efficiency by dividing the power of the exit beam $L_s$ by the total power emitted by the structure ($L_p + L_{out} + L_g$).

As an example, in the crystal CL of figure 4A, the angular coordinates of the normal to the beveled vertex in the xyz frame of reference are ($\alpha$=45°; $\beta$=35,3°). Figure 4C illustrates the coordinate in said frame of reference. For a rectangular parallelepiped crystal, this means that the normal $\vec{n}$ to the beveled edge has to be parallel to the sum of the normal of all the nearest faces : $\vec{n}_1 + \vec{n}_2 + \vec{n}_{11}$. Another representation of said normal is the coordinates (1; 1; 1) in the xyz frame of reference. For simplification, let us call this normal "optimal normal". For a crystal with a rectangular parallelepiped shape and the beveled vertex S1, this orientation of the normal ensures minimal overlap between the angles forming the escape cones created by the beveled vertex and those forming the cones of the untrapped rays. Images of the escape cone 1 by the crystal surfaces are cones 2, 5 and 4. Images of cone 2 are cones 1, 6 and 3, images of cones 3 are cones 2, 7 and 4 and images of cone 4 are cones 3, 8 and 1. Therefore, with multiple imaging, the beveled vertex SB1 of the crystal CL of figure 4A can recycle 8 cones of light into exit beam $L_s$. In theory, for a crystal of rectangular parallelepiped shape, the second variant of the invention can therefore lead to a light extraction efficiency 8 times higher than the light extraction efficiency of the prior art crystal of figure 1A.

However, to achieve this theorical limit of light extraction efficiency it is necessary that there is no overlap between the angles forming the escape cones created by the beveled edge or vertex and those forming the cones of the untrapped rays. Indeed, if such an overlap exists, the rays propagating in the crystal with an angle in that overlap range will "leak" out of the crystal through the side faces or the large faces and therefore not contribute to the increased luminance and power of the exit beam. This will lead to a relative decrease in light extraction efficiency. This means that this theorical limit is more easily achievable with crystals having a high refraction index (eg: diamond), because this will lead to a smaller critical angle $\theta_c$ and therefore will leave more "space" for the escape cones created by the beveled edge or index. Obviously, the value of this theorical limit of the light extraction efficiency is ultimately limited by the critical angle $\theta_c$ and the Snell-Descartes law.

Figure 3 is a planar representation of the escape cones $L_g$, $L_{out}$ and $L_s$ using angular coordinates ($\alpha,\beta$) in the *xyz* frame of reference. The lighter area in between the cones corresponds to the trapped rays $L_p$. This representation is given as an example, with respect to in the first variant of the invention, with a diamond crystal of rectangular shape and with beveled edge with an optimal normal. For diamond, the critical angle is $\theta_c$ = 24,6° assuming the ambient medium is air. From figure 3, one can see the 4 escape cones $L_s$ created by the beveled edge and their position relative to the other cones. Figure 3 shows that the optimal normal ensures minimal overlap between the escape cones $L_g$ and the escape cones $L_s$ created by the beveled edge AB1. Indeed, the center of the escape cones $L_s$ are aligned with the center of the escape cones $L_g$ and they are equidistant to the two closest centers of escape cones $L_g$. In the first variant of the invention, with a crystal of rectangular parallelepiped shape and with an optimal normal, there will be no overlap between the escape cones $L_g$, $L_{out}$ and the escape cones $L_s$ if the critical angle $\theta_c$ is lower than 22,5°.

Figure 4D is a planar representations of the escape cones $L_g$, $L_{out}$ and $L_s$ using angular coordinates ($\alpha,\beta$) in the *xyz* frame of reference. This representation is given as an example, with respect to in the second variant of the invention, with a diamond crystal of rectangular shape and with a beveled vertex with an optimal normal. From figure 4D, one can see the 8 escape cones $L_s$ created by the beveled vertex and their position relative to the other cones. Unlike in figure 3, in figure 4D, one can see that the optimal normal ensures no overlap between the escape cones $L_g$ and the escape cones $L_s$ created by the beveled edge AB1. Indeed, the center of the escape cones $L_s$ are centered on the $\beta = 35°$ line and they are equidistant to the two closest centers of escape cones $L_g$. As an example, in the second variant of the invention, with a crystal of rectangular shape and with a normal to the beveled vertex having ($\alpha$=45°; $\beta$=35,3°) angular coordinates in the xyz frame of reference, there will be no overlap between the escape cones $L_g + L_{out}$ and the escape cones $L_s$ if the critical angle $\theta_c$ is lower than

$$\frac{1}{2}\sqrt{\alpha^2 + \beta^2}=28,6°$$

If an overlap exists between the escape cones $L_g + L_{out}$ and the escape cones $L_s$, in an embodiment of the invention, the device 1 comprises a plurality of mirrors covering the side faces, except for the beveled edge or the beveled vertex. This leads to a recycling of the rays propagating with an angle inside that overlap range of angles which can then exit through the beveled edge or vertex instead of leaking out the crystal through the side faces or large faces. If the mirrors cover the appropriate faces of the crystal, they can increase the light extraction efficiency of the device up to the aforementioned theorical limit. By mirror, in this context, we mean reflecting surface with a reflection coefficient for the luminescent light higher than 50%, preferably higher than 90%, preferably higher than 99%.

In a preferred embodiment of the invention, the normal to the side faces are in the horizontal plane $xy$ (plane of the large faces). This means that the side faces are perpendicular to the large faces. In this configuration, the escape cones of the side faces are self-imaged by the larges faces considered as mirror. This geometry is advantageous to best recycle the trapped rays via the beveled edge or vertex and achieve the highest light extraction possible. Indeed, when the side faces are not perpendicular to the large faces, images of the escape cone of the side faces by the large face are not equal to those escape cones. Thus, there if there are $n$ side faces, there is $n$ escape cones associated with those side faces and $n$ images created by reflection on the other faces of the crystal. This implies that, when the side faces are not perpendicular to the large faces, it is more complex to achieve no overlap between the escape cone of the beveled surface and its images by reflection, and the $2n$ escape cones associated with the side faces (ie: the $n$ "real" escape cones and the $n$ images by reflection). Thus, for some geometry and for a given index of the crystal, the aforementioned embodiment where the side faces are perpendicular to the large faces can achieve a higher light extraction efficiency than when the side faces are not perpendicular to the large faces.

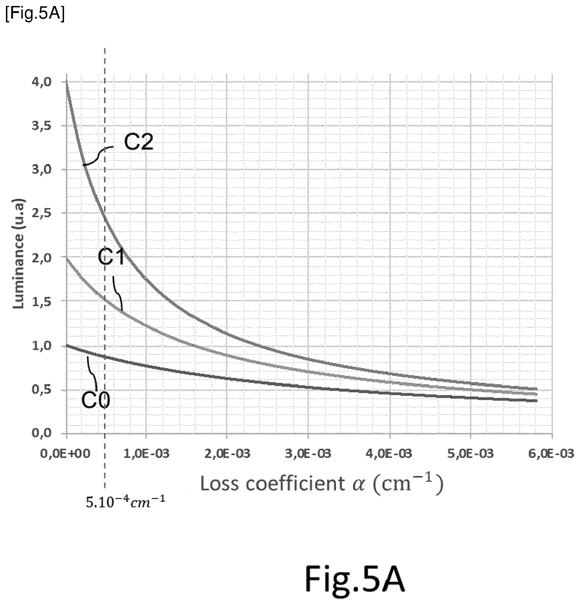

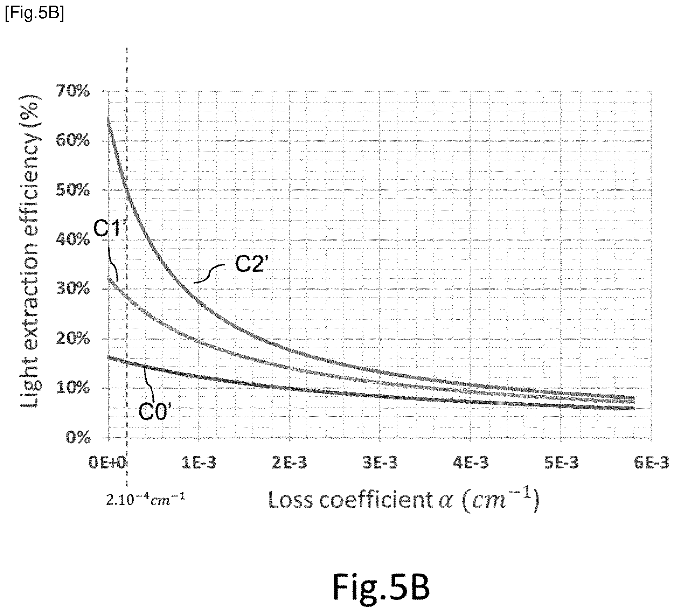

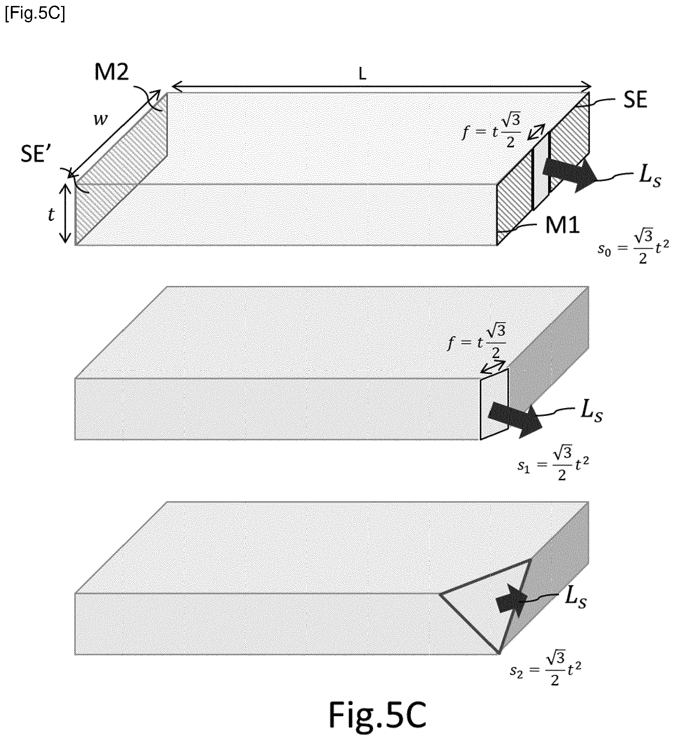

Figures 5A and 5B represent the luminance of the exit beam, and the extraction efficiency, respectively, in function of the attenuation coefficient $\alpha$ for different configurations of crystals. The different configurations are illustrated in figure 5C. The calculations were made using analytical equations. In all configurations, given as an example, the crystal is a rectangular shaped Ce:YAG crystal with $w = 14mm; L = 100mm; t = 1mm$ see figure 5C for the dimensions). In figures 5A and 5B, the C0 and C0' curves are taken from calculations based on the configuration corresponding to top configuration of figure 5C, in which a mirror is covering the entirety of the side face SE' and a mirror is partially covering the side face SE, thus defining an uncovered surface from which exits the exit beam ("exit face"). This configuration, called "prior art configuration A" is not an embodiment of the invention and, thanks to the mirrors, recycles two escape cones. The C1 and C1' curves are taken from calculations based on the first variant of the invention, with an optimal normal and corresponds to the middle configuration of figure 5C. Finally, the C2 and C2' curves are taken from calculations based on the second variant of the invention, with an optimal normal and corresponds to the bottom configuration of figure 5C.

For both figures 5A and 5B, the surface of the exit face (uncovered surface in Prior art configuration A, beveled edge for the C1 curve and beveled vertex for the C2 curve) is equal to $\frac{\sqrt{3}}{2}t^2 = 0.86 \text{ mm}^2$ in all configurations. For the calculation of figure 5A, the assumption was made that the emission of the exit beam just after the exit face is lambertian and the value of luminance have been divided by the luminance value of the exit beam $L_s$ of the Prior art configuration A for $\alpha = 0\ cm^{-1}$.

One can see from figures 5A and 5B, that, for $\alpha > \frac{1}{10 \times 2L} = 5.10^{-3} cm^{-1}$, the first and the second variant of the invention lead to a marginally better extraction efficiency and an exit beam with higher luminance than the Prior art configuration A. However, for $\alpha$ < $5.10^{-3} cm^{-1}$ (ie $\frac{1}{\alpha} \gg 2L$ ), the first and the second variant of the invention lead to significantly better extraction efficiency and an exit beam with much higher luminance than the Prior art configuration A. For example, for $\alpha = 5.10^{-4} cm^{-1}$, the luminance of the exit beam $L_s$ in the prior art configuration A is 0.75 ua, whereas the luminance of the exit beam $L_s$ in the first variant of the invention is 1.5 ua, and the luminance of the exit beam $L_s$ in the second variant of the invention is 2.5 ua. For $\alpha = 5.10^{-4} cm^{-1}$, the extraction efficiency in the prior art configuration A is 14%, whereas it is 24% in the first variant of the invention and 38% in the second variant of the invention. The light extraction efficiency reaches over 50% for $\alpha = 2.10^{-4} cm^{-1}$ in the second variant of the invention whereas for the prior art configuration A it is still merely 15%.

One can show that rays exiting through the beveled edge or vertex of the crystal of the invention have a mean path longer than rays exiting side face SE in the prior art crystal of figure 1A. This explains the relative greater impact of an increase of the attenuation coefficient $\alpha$ on the luminance and the extraction efficiency in the first and second variant of the invention than in the prior art configuration A.

It will be noted that the surface of the beveled edge or vertex has direct influence on the mean path $L_{mean}$ of the rays exiting through the beveled edge or vertex. For example, for the second variant of the invention, with an optimal normal (bottom configuration of figure 5C), the mean length is $L_{mean} =$

$$2L\left(\sqrt{3}\left(2\frac{4wt}{\sqrt{3}}/s_2 - 1\right)\right),$$

with $s_2$ the area of the beveled vertex. Preferably and to benefit more greatly from the advantages granted by the configurations of the invention, the crystal CL of the invention has an attenuation coefficient of the luminescent light $\alpha$ such that

$$\frac{1}{\alpha} \gg 2L.$$

In the more general case where the crystal is not rectangular in shape, $L$ is the maximum distance between two parallel side faces.

Figures 5A and 5B show that both the value of luminance of the exit beam and the value of the light extraction efficiency are higher in the configuration of the second variant of the invention than in the configuration of the first variant of the invention. The gap between the two configurations increases as $\alpha$ gets smaller. This is explained by the number of escape cones $L_g$ recycled in the second variant of the invention which is 8, twice the number of escape cones $L_g$ recycled in the first variant of the invention, 4.

Figure 6A illustrates a light emitting device 1 according the second variant of the invention wherein the crystal CL has 6 side faces, parallel two by two. In this embodiment, n = 6 and the normals to the side faces are invariant by rotation by an angle of $\pi/3$ in the horizontal plane around the z-axis. The normal to the beveled vertex S1 is parallel to the sum of the normal of the three faces forming the vertex $\vec{n}_1 + \vec{n}_2 + \vec{n}_{11}$. It is the "optimal" normal for this geometry. Figure 6B is a representation of the angular diagram of all the rays emitted and trapped in the crystal CL of figure 6A. As shown in figure 6B, given the geometry of the crystal, the beveled vertex has created 12 artificial escape cones. Therefore, in theory, the second variant of the invention can lead to a light extraction efficiency 12 times higher than the light extraction efficiency of the prior art crystal of figure 1A if there is no overlap between the escape cones $L_g$, $L_{out}$ and $L_s$.

In an embodiment of the invention, compatible with the first and the second variant of the invention, the crystal is a diamond that comprises nitrogen vacancy centers. NV (nitrogen vacancy) centers are impurities created by irradiation in diamonds and used for their fluorescence properties. In this embodiment, the incident radiation Ld being emitted by a laser illuminating at least one of the large faces. Typically, they absorb green light and emit red light. Given the index of the diamond n = 2.4, the light exiting into the air through a face of a parallelepiped represents 4.5% of the total light. In general, the light is collected by a confocal microscope. For example, with a numerical aperture of 1.35 (immersion objective), the light collected represents a maximum of 8.6% of the light emitted. The sensitivity of the experiments depending on the amount of signal collected, many strategies have been tried to increase this value. Thus, the diamond crystal CL of the invention can drastically increase the light extraction efficiency. As an example, in the second variant of the invention, with a rectangular shaped crystal in ambient air and an optimal normal, 8 escape cones can be recycled in the exit beam $L_s$. This means that the light extraction efficiency is $4,5 \times 8 = 36\%$ in this example.

The control on the surface size of the beveled vertex makes it possible to use photodectectors of smaller surface which have a very short response time, necessary for experiments with NV centers (lifetime of about ten ns, interrogation sequence of transitions in the $\mu$s domain), while collecting a maximum of flux.

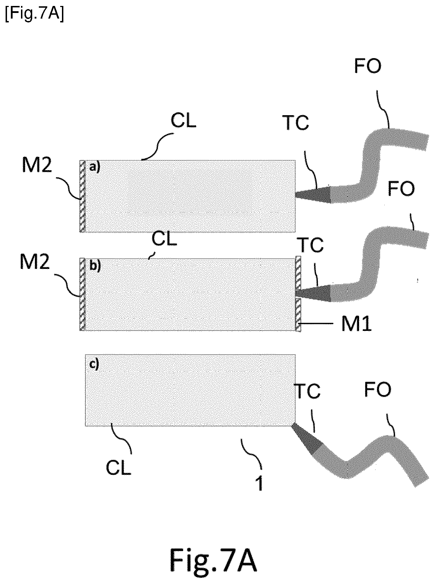

Figure 7A illustrates different configurations of crystals coupled with an optical fiber FO via a tapered conical adapter TC.

The bottom configuration of figure 7A illustrates an embodiment of the invention, compatible with the first and the second variant of the invention. Given as an illustrative example, in figure 7A the crystal of rectangular shape is according to the second variant of the invention and comprises a beveled vertex with an optimal normal. In this embodiment, the device 1 comprises a tapered conical adapter TC attached by a so-called upstream end adjacent to the beveled edge or vertex. By "attached", it is meant that, the upstream end is for example glued with an intermediate medium of index $n'$ with a very thin thickness. The device 1 comprises an optical fiber FO connected to a so-called downstream end of the tapered adapter. The tapered adapter TC is adapted to match a numerical aperture of the exit beam $L_s$ to a numerical aperture $ON_f$ of said optical fiber. It is adapted to guide the rays of the exit beam into the optical fiber by TIR over its faces. In a preferred embodiment, the faces of the adapter are treated with a metallic or dielectric coating to improve reflectivity of the $L_s$ beam.

To ensure the conservation of the etendue (or throughput), the diameter of the upstream end $\phi_u$ and the diameter of the downstream end $\phi_d$ are linked by the following relationship $\phi_u \times n \times \sin\theta_m = \phi_d \times ON_f$, with n the index of the crystal CL and $\theta_m$ the collection angle inside the crystal of the rays that will be guided in the fiber. If a glue of index $n'$ is used as an intermediate medium, we have : $\phi_u \times n \times \sin\theta_m = \phi_u \times n' \times \sin\theta'_m = \phi_d \times ON_f$. To collect more rays than by direct coupling of the fiber to the emitting medium, it is necessary that the numerical aperture at the input of the cone is larger than the numerical aperture at the output. This implies that $\phi_u < \phi_d$. It should be noted that the diameter of the upstream end $\phi_u$ is limited by a minimum value that depends on the index n' of the intermediate medium. Assuming the numerical aperture of the adapter is sufficient to collect all possible angles, and $\theta'_m = 90°$, we need:

$$\phi_d > \phi_d \times ON_f/n' \text{ (Eq1)}.$$

Top configuration of figure 7A is a prior art configuration ("prior art configuration B") where the fiber is simply positioned on the output side of the crystal ("butt coupling"), with the aperture adapter TC and a mirror M2 on the face opposite the adapter, to increase the collected light flux.

Middle configuration of figure 7A (called prior art configuration A') corresponds to the prior art configuration A, with mirrors placed on the output face in order to concentrate the light on the output area where the adapter TC is located.

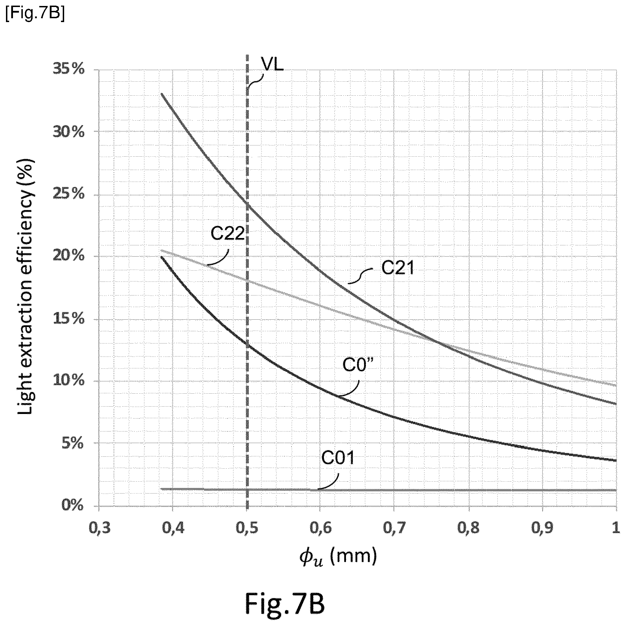

Figure 7B represents the light extraction efficiency, in function the diameter of the upstream end $\phi_u$, for the different configurations of crystals illustrated in figure 7A.

The curves in figure 7B corresponding to the embodiment of the invention illustrated in the bottom figure of figure 7A are the curves C21 and C22.

In the calculations of the C21 curve, the core of the fiber (or its "antecedent" by the cone) is inscribed in the output area, that is the beveled edge or vertex surface ("C21 configuration"). In this case, the fiber does not collect all the rays that come out of the exit face.

In the calculations of the C22 curve the core of the fiber completely encompasses the output area ("C22 configuration"). In this case, all the rays exiting the beveled edge or vertex are coupled into the fiber. However, this is done at the cost of an output area 4 times smaller than in the C21 configuration. The exit probabilities through the zone in question are therefore much lower, lengthening the propagation length in the medium before finding the exit.

The curve corresponding to the prior art configuration A' of figure 7B is curve C0 in figure 7A.

The curve corresponding to the prior art configuration B of figure 7B is curve C01 in figure 7A.

In the three configurations of figure 7A, given as an example for calculating the curves of figure 7B, the crystal is rectangular in shape with dimensions $w = 2.5mm$; $L = 50mm$; $t = 1mm$ and $\alpha = 2.10^{-3}cm^{-1}$. The optical fiber has a 1mm core diameter and a numerical aperture $ON_f = 0.5$. The calculation were made assuming no overlap between the escape cones.

In figure 7B, the vertical line VL $x_{VL} = 0.5mm$, separates the curves C0, C01, C22, C21 into efficiency values that are only achievable with an intermediate medium of index $n' > 1$ (for $\phi_u < x_{VL}$) and efficiency values that are achievable without an intermediate medium (for $\phi_u > x_{VL}$). This vertical line is given by Eq1. As an illustrative example, in figure 7B, $n' = 1.4$.

The curve C01 in figure 7B shows that the efficiency is very low in the prior art configuration a) (about 1%). When $\phi_u = \phi_d = 1mm$ (the equivalent of coupling without an adapter cone), the embodiment of the invention (see curves C21 and C22) already gives an improvement of factor of 8 compared to the coupling of the prior art configuration A (C01 curve) and an improvement of factor of 2 compared to the prior art configuration A' (C0" curve). For $\phi_u = 0.5$ $mm$, this improvement factor goes to 18 for the C22 configuration and to 24 for the C21 configuration. Finally, for $\phi_u = 0.4$ $mm$ the improvement factor goes to 32 for the C21 configuration.

Figure 7B clearly illustrates the advantage brought by the combined use of the crystal of the invention with a beveled edge or vertex and the adapter TC to achieve high extraction efficiency of the exit beam $L_s$ in an optical fiber.

From figure 7B, one can see that the smaller the diameter of the upstream end $\phi_u$ gets, the better the C21 configuration of the invention gets compared to the C22 configuration. This is due to the fact that the mean path distance of the rays in the crystal CL before exiting the beveled edge or vertex is greater in the C22 configuration than in the C21 configuration. Thus, the propagation losses in the C22 limit the extraction efficiency.

Another object of the invention concerns scintillator crystals. As previously stated, the energy resolution of scintillators depends greatly on the light extraction efficiency of the crystal. Scintillators are often assembled in the form of arrays in order to perform X-ray/gamma imaging. For compactness reason, a crystal with parallelepiped geometry is most often chosen. A critical parameter of this imaging method is the pixel density, where each scintillator of the array represents a pixel. Indeed, in the case of scattering surfaces, it is necessary to optically isolate the crystals from each other by reflectors in order to avoid "crosstalks". That is to say, to avoid that the light emitted in a first crystal is detected as coming from a second crystal because coming out by a face of the second crystal.

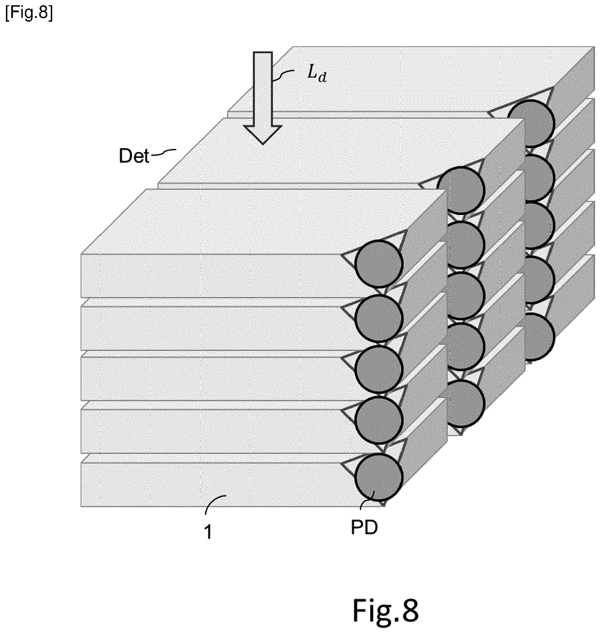

To alleviate certain problems of the prior art, another object of the invention is an x-ray or gamma-ray imaging system comprising an x-ray or gamma-ray source and a detector Det. The detector Det is illustrated in figure 8 and comprises a plurality of identical light emitting devices 1 according to the first or second variant of the invention. Given as an illustrative example, the crystal of each device is according to the second variant of the invention and comprises a beveled vertex. In the embodiment of figure 8, the crystal of each device is a solid scintillator. The devices 1 are arranged to form an array, thus forming a pixelated detector for the incident radiation Ld emitted by the x-ray or gamma-ray source. To collect the visible exit beams passing through the beveled edge or vertex, the imaging system comprises a plurality of photodiodes PD each arranged opposite of the beveled edge or the beveled vertex of the crystal of each device. Thus, in the imaging system of the invention, a single pixel is formed by a device 1 plus its corresponding photodiode PD. Preferably, all the faces of the crystals are optically polished.

Compared to scintillator detector arrays of prior art, a crucial advantage of the imaging system using the detector of figure 8, is that cross talk is not an issue. This is due to the fact that in detector Det, the rays exiting the beveled edge or the beveled vertex and detected by each photodiode are exclusively trapped rays coming from the crystal arranged opposite to the photodiode. Indeed, un-trapped rays that exit any crystal of the array, by any given face, will not be trapped by another crystal of the array because they are identical and have the same escape cones. Thus, an un-trapped ray that exits any crystal of the array will propagate through all the crystal of the detector in its path and not be detected by any photodiode PD because of the position of the photodiodes PD.

Having an area of the beveled edge or the beveled vertex of the crystal that is smaller than the area of the side faces between the beveled edge or the beveled vertex makes it possible to use photodiodes of smaller surface which have a very short response time, while collecting a maximum of flux. Thus, preferably, the surface of the photodiodes and the surface of the beveled edge or vertex are smaller than the surface of the side faces between the beveled edge or vertex.

**Claims**

1. Light emitting device (1) comprising a solid fluorescent material or a solid scintillator material (CL) adapted to absorb an incident light (Ld) and then emit a luminescent light ($L_L$) in said material, a portion, called trapped portion (Lp), of said luminescent light being trapped by total internal reflections in said material, said material comprising two parallel faces, called large faces (FE1, FE2), along an horizontal

$$n \in \mathbb{N} > 2$$

plane *xy,* and faces called side faces (FL1, FL2, FL3, F4), and forming vertex (S2, S3, S4) between two adjacent side faces and a large face,

wherein said material has an invariance of the normals to said side faces by rotation by an angle of 2 $\pi/n$. in said horizontal plan around a *z* -axis perpendicular to said horizontal plane, wherein said material has a vertex called virtual vertex (S1) that is beveled thus forming a surface called beveled vertex (SB1), a portion of the rays of said trapped portion passing through said beveled vertex thus forming an exit beam ($L_S$),
wherein a normal ($\vec{n}$) to said beveled vertex is parallel to the sum of the normal of the faces forming said virtual vertex, within$\pm 10°$.

2. A device according to any of the preceding claims, wherein said material is a rectangular parallelepiped.

3. A device according to the preceding claim, wherein an angular coordinates of said normal to said beveled vertex in an xyz frame of reference are ($\alpha$-$\pm45°$;$\beta$-$\pm35,3°$) $\pm 10°$.

4. Light emitting device (1) comprising a solid fluorescent material or a solid scintillator material (CL) adapted to absorb an incident light (Ld) and then emit a luminescent light ($L_L$) in said material, a portion, called trapped portion (Lp), of said luminescent light being trapped by total internal reflections in said material, said material comprising two parallel faces, called large faces (FE1, FE2), along an horizontal

$$n \in \mathbb{N} > 2$$

plane *xy,* and faces called side faces (FL1, FL2, FL3, FL4)

wherein said material has an invariance of normals to said side faces by rotation by an angle of 2 $\pi/n$ in said horizontal plan around a z -axis perpendicular to the horizontal plane, wherein said material has an edge between two side faces, called virtual edge (S1S5), that is beveled thus forming a surface beveled edge (SB1), a portion of the rays of said trapped portion passing through said beveled edge forming an exit beam ($L_S$),
wherein the normal ($\vec{n}$) to said beveled vertex is parallel to the sum of the normal of the two side faces forming the virtual edge, within $\pm 10°$.

5. A device according to any of the preceding claims, comprising a plurality of mirrors covering said side faces except for said beveled edge or said beveled vertex.

6. A device according the any of preceding claims, wherein said material has an attenuation coefficient of said luminescent light $\alpha$ such that $\frac{1}{\alpha} \gg 2L,$ with $L$ a maximum distance between two parallel side faces.

7. A device according to any of the preceding claims, wherein said material is a diamond crystal having nitrogen vacancy centers, said incident radiation (Ld) being emitted by a laser illuminating at least one face of the crystal.

8. A device according to any of the preceding claims, wherein the side faces are perpendicular to the large faces.

9. A device according to any of the preceding claims, comprising a tapered conical adapter attached by a so-called upstream end adjacent to said beveled edge or vertex and an optical fiber connected to a so-called downstream end of the tapered adapter, said tapered adapter matching a numerical aperture of said exit beam to a numerical aperture of said optical fiber.

10. An x-ray or gamma-ray imaging system comprising an x-ray or gamma-ray source and a detector (Det) comprising:

   - a plurality of identical light emitting devices (1) according to any of the preceding claims, arranged to form an array, said material of each device being a solid scintillator,
   - a plurality of photodiodes (PD) each arranged opposite of said beveled edge or said beveled vertex of the material of each device.

[Fig.1A]

FIG.1A

[Fig.1B]

FIG.1B

[Fig.2A]

S3  $L_d$  FE1  S4

L

S2  $L_L$  S1  $\vec{n}$  FL1

1  FL2  CL  $L_{out}$  $L_g$ et $L_p$  AB1  S5  $L_s$

z

y

x

Fig.2A

[Fig.2B]

z

$L_p$

3  2

4  1  y

x  $L_s$

$L_{out}$ et $L_g$  Fig.2B

[Fig.2C]

Fig.2C

[Fig.3]

Fig.3

[Fig.4A]

Fig.4A

[Fig.4B]

$L_{out}$ et $L_g$  Fig.4B

EP 4 106 022 A1

[Fig.4C]

Fig.4C

[Fig.4D]

Fig.4D

16

[Fig.5A]

Fig.5A

[Fig.5B]

Fig.5B

[Fig.5C]

Fig.5C

[Fig.6A]

$$z$$
$$y$$
$$x$$

S4
$L_d$
S5

S3 FE1
S6

S2
S1

FL3
CL

FL2
FL1

$L_s$

Fig.6A

[Fig.6B]

z

$L_p$
$L_s$

x
y

$L_{out}\ et\ L_g$

Fig.6B

[Fig.7A]

Fig.7A

[Fig.7B]

Fig.7B

[Fig.8]

Fig.8

Europäisches
Patentamt

European
Patent Office

Office européen
des brevets

# EUROPEAN SEARCH REPORT

Application Number

EP 21 30 5827

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/107635 A1 (NEWMAN DAVID EDWARD [US]) 11 April 2019 (2019-04-11) | 1-3,6,8, 10 | INV. H01L33/50 G01T1/20 |
| A | * paragraphs [0065] - [0123]; figure 7 * | 4,5,7,9 | |
| X | US 2016/054501 A1 (HIKMET RIFAT ATA MUSTAFA [NL] ET AL) 25 February 2016 (2016-02-25) | 1-9 | ADD. H01L25/075 |
| A | * paragraphs [0052] - [0059], [0093] - [0099]; figures 6,7 * | 10 | |
| X | JP 2021 081297 A (MITSUBISHI ELECTRIC CORP) 27 May 2021 (2021-05-27) * paragraphs [0012] - [0057]; figures 1,11,12 * | 1-10 | |
| A | RU 2 623 688 C1 (AKTSIONERNOE OBSHCHESTVO NAUCHNO-ISSLEDOVATELSKIJ INST POLYUS IM M F S) 28 June 2017 (2017-06-28) * the whole document * | 1-10 | |
| A | HEINZIG MATTHIAS ET AL: "High-power single-pass pumped diamond Raman laser", 2017 CONFERENCE ON LASERS AND ELECTRO-OPTICS EUROPE & EUROPEAN QUANTUM ELECTRONICS CONFERENCE (CLEO/EUROPE-EQEC), IEEE, 25 June 2017 (2017-06-25), page 1, XP033239198, DOI: 10.1109/CLEOE-EQEC.2017.8086252 [retrieved on 2017-10-26] * the whole document * | 7 | TECHNICAL FIELDS SEARCHED (IPC) H01L G01T |
| A | US 2006/233492 A1 (SCHAAFSMA DAVID T [US]) 19 October 2006 (2006-10-19) * the whole document * | 9 | |

The present search report has been drawn up for all claims

| Place of search | Date of completion of the search | Examiner |
|---|---|---|
| The Hague | 1 December 2021 | Simeonov, Dobri |

EPO FORM 1503 03.82 (P04C01)

## ANNEX TO THE EUROPEAN SEARCH REPORT
## ON EUROPEAN PATENT APPLICATION NO.

EP 21 30 5827

This annex lists the patent family members relating to the patent documents cited in  the above-mentioned European search report.
The members are as contained in the European Patent Office EDP file on
The European Patent Office is in no way liable for these particulars which are merely given for the purpose of information.

01-12-2021

| Patent document cited in search report | | Publication date | Patent family member(s) | | Publication date |
|---|---|---|---|---|---|
| US 2019107635 | A1 | 11-04-2019 | US 10101472 | B1 | 16-10-2018 |
| | | | US 2019107635 | A1 | 11-04-2019 |
| | | | US 2020309966 | A1 | 01-10-2020 |
| US 2016054501 | A1 | 25-02-2016 | CN 105074945 | A | 18-11-2015 |
| | | | EP 2979310 | A1 | 03-02-2016 |
| | | | JP 6396419 | B2 | 26-09-2018 |
| | | | JP 2016521438 | A | 21-07-2016 |
| | | | US 2016054501 | A1 | 25-02-2016 |
| | | | WO 2014155250 | A1 | 02-10-2014 |
| JP 2021081297 | A | 27-05-2021 | NONE | | |
| RU 2623688 | C1 | 28-06-2017 | NONE | | |
| US 2006233492 | A1 | 19-10-2006 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BARBET, ADRIEN et al.** Light-emitting diode pumped luminescent concentrators: a new opportunity for low-cost solid-state lasers. *Optica,* 2016, vol. 3.5, 465-468

- **C.M ANKENBRANDT ; E.M.LENT.** Increasing the light collection efficiency of scintillation counters. *RSI,* 1963, vol. 34 (6), 647